# EUROPEAN PATENT APPLICATION

(11) **EP 0 574 934 A1**
(43) Date of publication of application: **22.12.1993**
(21) Application number: 93109739.8
(22) Date of filing: 18.06.1993
(51) Int. Cl.: G03F 7/038

(54) **Method for forming a patterned polyimide coating film on a substrate**

(30) Priority: 19.06.1992 JP 161250/92
(71) Applicant: E.I. DU PONT DE NEMOURS & COMPANY INCORPORATED, Wilmington Delaware 19898 (US)
(72) Inventor: Yamamoto, Yasuhisa, Yokohama-shi, Kanagawa-ken 222 (JP)
(74) Representative: von Kreisler, Alek, Dipl.-Chem.

(57) **Abstract**

A method wherein an optically-cross-linkable polymer composition obtained by modifying a polyimide precursor by using a photosensitive group-containing compound is applied to the surface of a substrate in such a way that a coating film will be formed, wherein the resulting coating film is exposed imagewise, wherein non-exposed segments are solubilized and removed by using a development solution, and wherein the remaining coating film in the exposed segment is heated and converted into a polyimide resin, a development solution which contains 1-30 wt% of dimethyl sulfoxide is employed in the development process.

## Description

### FIELD OF INVENTION

The present invention concerns a method wherein protective films, insulating films, interlayer insulating layers, passivation films, recording elements, press-making materials, etc. are produced by using an optically-cross-linkable polymer composition obtained by modifying a polyimide precursor with a photosensitive group-containing compound in the fields of imaging (e.g., semiconductor production industry, microelectronic industry, photographic press-making, holograms, laser recording, etc.).

In the paragraphs to follow, a method wherein a coating film obtained by applying the aforementioned optically-cross-linkable polymer composition to the surface of a substrate is exposed imagewise and wherein non-exposed segments are removed for the purpose of producing a certain pattern on the substrate.

### BACKGROUND OF THE INVENTION

In recent years, resins which possess heterocyclic groups as molecule constituent units (e.g., polyimide resins, etc.), which exhibit high heat resistances and excellent electrical and mechanical properties, have been used as integrated element insulating films, passivation films, or high-density mounting substrate interlayer insulating films in the semiconductor production industry and microelectronic industry.

In a case where an insulating film is formed by using said resin, it becomes necessary to form a circuit between a metal or electroconductive material which constitutes a layer beneath said insulating film and another electronic element or device. In a case where an interlayer insulating film is formed by using said resin, too, it oftentimes becomes necessary to achieve conduction by establishing an electroconductive path between upper and lower layers. In such a case, a bore hole is formed on a resin film, and the upper and lower layers are connected via an electroconductive material through said bore hole. Such an insulating film or interlayer insulating film is formed by using a photosensitive polyimide precursor composition with an excellent processibility, and the insulating film or interlayer insulating film is patterned in a desired fashion by a pattern formation method.

The following processes may be implemented in the aforementioned pattern formation method which utilizes said photosensitive polyimide precursor composition: (1) coating: a polyimide precursor compositiqn varnish is coated on a substrate; (2) baking: the solvent within said composition varnish is evaporated for forming a coating film; (3) exposure: exposure is carried out by using an ultraviolet exposure device and a certain photomask; (4) development: non-exposed segments are dissolved and removed by using a development solution, and after washing has been performed by using a rinsing solution, a pattern is obtained; (5) curing: the resin is heated and converted into a polyimide resin.

Optical recording materials (e.g., press-making materials, etc.) obtained by using photosensitive polyimide precursor compositions have captured considerable attention due to their excellent mechanical strengths, etc. in the fields of photographic press-making and imaging.

When a coating film consisting of said photosensitive polyimide precursor is exposed imagewise and when non-exposed segments are dissolved and removed by using a development solution, a mixed solution consisting of N-methyl-2-pyrrolidone, methanol, and water may be employed as said development solution.

When attempts are made to produce a patterned polyimide film by the aforementioned method, an extremely long development time is required for achieving a high resolution and for preventing the presence of residual non-exposed segments, which is undesirable in consideration of the process management of productivity.

In order to eliminate these shortcomings, attempts have been made to shorten the development time by shortening the baking time of the aforementioned composition varnish or by lowering the baking temperature. In such a case, the development time is shortened, but the resolution deteriorates, and as a result, it becomes impossible to completely remove the non-exposed segments. Moreover, the bottom of the film is shaved (i.e., undercut). It has become urgent to achieve a development method which is unaccompanied by these problems.

The present inventors compiled exhaustive research in order to solve the aforementioned problems of conventional methods, and as a result, the present invention had been completed after a development solution with the following characteristics had been developed: in a case where a coating film obtained by coating a photosensitive polyimide precursor composition on a substrate is exposed imagewise and then developed, it enables the formation of a pattern which is unaccompanied by residual non-exposed segments in high resolution over an abbreviated development time.

### SUMMARY OF THE INVENTION

Put succinctly, the present invention concerns a method for forming a patterned polyimide coating film on a substrate with the following characteristics: in a method wherein an optically-cross-linkable polymer composition obtained by modifying a polyimide precursor derived from an aromatic tetracarboxylic acid or a corresponding mono- or diacid anhydride and an aromatic diamine by using a photosensitive group-containing compound is applied to the surface of a substrate in such a way that a coating film will be formed, wherein the resulting coating film is exposed imagewise, wherein non-exposed segments are solubilized and removed by using a development solution, and wherein the remaining coating film in the exposed segment is heated and converted into a polyimide resin, a mixed solvent [solution] which contains at least 1 wt% and no more than 30 wt% of dimetryl sulfoxide is employed as said development solution.

### DETAILED DESCRIPTION OF THE INVENTION

If the aforementioned development solution is used in the present invention, the development time is shortened, and a patterned polyimide coating film which is unaccompanied by residual non-exposed segments can be obtained within an abbreviated development time in a high resolution.

The optically-cross-linkable polymer composition employed in the present invention is obtained by modifying a polyimide precursor (i.e., polyamic acid) derived from an aromatic tetracarboxylic acid or corresponding mono- or diacid anhydride and an aromatic diamine represented by the following general formula I: (chemical 1): 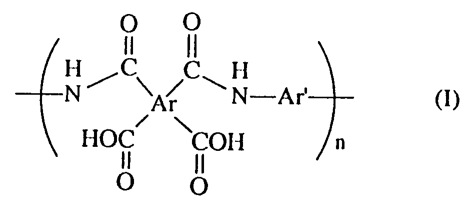
(wherein Ar is (chemical 2)) 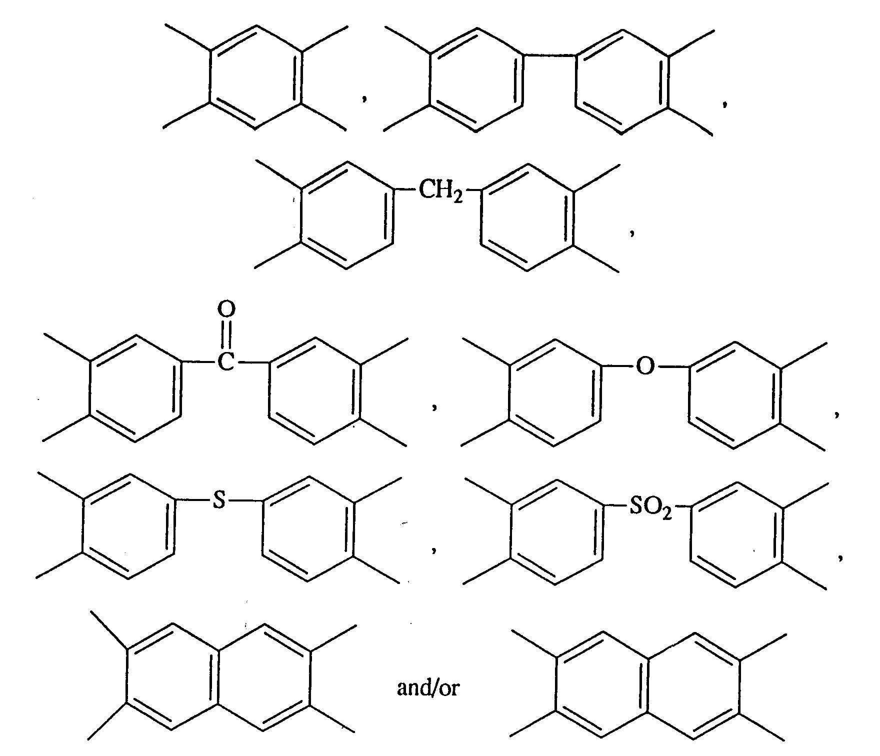
Ar' is (chemical 3): 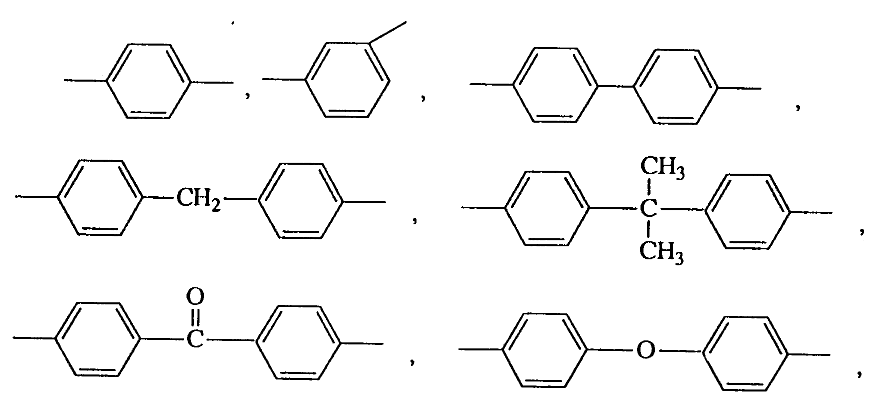
n, which pertains to the number of polyamic acid repetition units, is 1, 2, or larger) by using a photosensitive group-containing compound.

Concrete examples of aromatic tetracarboxylic acid dianhydrides employed for manufacturing the aforementioned polyamic acid include pyromellitic dianhydride (PMDA), 3,4,3',4'-benzophenonetetracarboxylic acid dianhydride (BTDA), 1,4,5,5-naphthalenetetracarboxylic acid dianhydride, 2,3,6,7-naphthalenetetracarboxylic acid dianhydride, 1,2,5,6-naphthalenetetracarboxylic acid dianhydride, 3,3',4,4'-diphenyltetracarboxylic acid dianhydride, 2,2',3,3'-diphenyltetracarboxylic acid dianhydride, 2,3,3',4'-diphenyltetracarboxylic acid dianhydride, 2,2-bis(3,4-dicarboxyphenyl)propane dianhydride, 2,2-bis(4-(3,4-dicarboxyphenoxy)phenyl)propane dianhydride, 2,2-bis(4-(2,3-dicarboxyphenoxy)phenyl)propane dianhydride, bis(3,4-dicarboxyphenyl)sulfone dianhydride, bis(3,4-dicarboxyphenyl) ether dianhydride, bis(3,4-dicarboxyphenyl)methane dianhydride and perylene-3,4,9,10-tetracarboxylic acid dianhydride, diphenylthioethertetracarboxylic acid dianhydride, diphenylsulfonetetracarboxylic acid dianhydride, and their mixtures.

Concrete examples of aromatic diamines, which are the other components used for manufacturing the aforementioned polyamic acid, include m- or p-phenylenediamine, 4,4'- or 3,3'-diaminobiphenyl, 4,4'- or 3,3'-diaminodiphenyl ether, 4,4'- or 3,3'-diaminodiphenylmethane, 4,4'- or 3,3'-diaminodiphenylsulfone, 4,4'- or 3,3'-thiodianiline, bis(4-aminophenyl)bis(trifluoromethyl)methane, 4,4'-diaminobenzophenone, 1,5-diaminonaphthalene, bis(4-aminophenyl)dimethylsilane, bis(4-aminophenyl)diethylsilane, bis(4-aminophenyl)diphenylsilane, bis(4-aminophenyloxy)dimethylsilane, bis(4-aminophenyl)ethylphosphine oxide, N-(bis(4-aminophenyl))-N-methylamine, N-(bis(4-aminophenyl))-N-phenylamine, 4,4 '-methylenebis(o-chloroaniline), 4,4'-methylenebis(3-methylaniline), 4,4'-methylenebis(2-ethylanilene) [sic], 4,4'-methylenebis(2-methoxyaniline), 5,5'-methylenebis(2-aminophenol), 4,4'-methylenebis(2-methylaniline), 4,4'-oxybis(2-methoxyaniline), 4,4'-oxybis(2-chloroaniline), 5,5'-oxybis(2-aminophenol), 4,4'-thiobis(2-methylaniline), 4,4'-thiobis(2-methoxyaniline), 4,4'-thiobis(2-chloroaniline), 4,4'-sulfonylbis(2-methylaniline), 4,4'-sulfonylbis(2-ethoxyaniline), 4,4'-sulfonylbis(2-chloroaniline), 5,5'-sulfonylbis(2-aminophenol), 3,3'-dimethyl-4,4'-diaminobenzophenone, 3,3'-dimethoxy-4,4'-diaminobenzophenone, 3,3'-dichloro-4,4'-diaminobenzophenone, 4,4'-oxydianiline, 4,4'-isopropylideanedianiline, 3,3'-dichlorobentidine, 3,3'-dimethylbentidine, 3,3'-dimethoxybentidine, 3,3'-dicarboxybentidine, diaminotoluene, 4,4'-methylenebis(3-carboxyaniline), and corresponding various esters, 5-amino-1-(4-aminophenyl)-1,3,3-trimethylindane and 6-amino-1-(4'-aminophenol)-1,3,3-trimethylindane [sic], and their mixtures.

This polyimide precursor is modified by using a photosensitive group-containing compound by mixing the polyimide precursor with said photosensitive group-containing compound or by introducing a photosensitive group to the side chain of the polyimide precursor.

Concrete examples of photosensitive group-containing compounds which are mixed with the polyimide precursor include compounds which are known as photosensitive monomers such as (meth)acrylates (e.g., trimethylolpropane triacrylate, trimethylolpropane trimethacrylate, polyethalene glycol diacrylate, polyethylene glycol dimethacrylate, N,N-dimethylaminoethyl methacrylate, etc.), mercapto compounds (e.g., thioglycolic acid, etc.), maleimides (e.g., phenylsulfonylmaleimide, etc.), isocyanates (e.g., ethyl methacrylate isocyanate, etc.), etc. The quantity of the photosensitive monomer mixed with the polyimide precursor is 0.01-100 wt%.

Representative examples of photosensitive groups introduced to the side chain of the polyimide precursor are groups which possess carbon-carbon double bonds such as a vinyl group, allyl group, acryl group, methacryl group, cinnamyl group, maleimido group, etc., although these examples do not constitute an exhaustive list. These photosensitive groups may be introduced to the side chain of the polyimide precursors via chemical bonds (e.g., ester bonds, amide bonds, urethane bonds, urea bonds, etc.), or they may be directly introduced to aromatic nuclei for photosensitizing the polyimide precursor.

Concrete examples of compounds which can be used for introducing the photosensitive groups to the side chain of the polyimide precursor include cinnamic acid, cinnamic chloride, α-cyanocinnamic chloride, cinnamylideneacetic chloride, α-cyanocinnamylideneacetic chloride, furylacrylic alicyclic, glycidyl cinnamate, ethyl methacrylate isocyanate, etc.

Sensitizers may be added to the aforementioned optically-cross-linkable polymer composition obtained by modifying the polyimide precursor with the photosensitive group-containing compound for the purpose of improving the photosensitivity. Concrete examples of such sensitizers include benzophenones (e.g., benzophenone, 4,4'-bis(dimethylamino)benzophenone, etc.), benzoin ether, anthraquinone, or thioxanthone derivatives, bisazides (e.g., 2,6-bis(4'-diethylaminobenzyl)cyclohexanone, etc.), mercapto compounds (e.g., 1-phenyl-5-mercaptotetrazole, etc.), oximes (e.g., 1-phenyl-1,2-propanedione-2-(o-ethoxycarbonyl)oxime, etc.), imidazoles (e.g., 2,4,5-triphenylimidazolyl dimer, etc.), etc.

The optically-cross-linkable polymer composition prepared according to the aforementioned procedures is preferably dissolved in a solvent in such a way that the viscosity will be lowered in a diluted state before it is applied to a substrate. Concrete examples of applicable solvents include N,N'-dimethylformamide, N,N'-dimethylacetamide, τ-butyrolactone, N-methylpyrrolidone, etc. These examples, however, do not constitute an exhaustive list.

The optically-cross-linkable polymer composition which has been diluted by the solvent is subsequently applied to a substrate. Representative examples of substrate application methods include the spin coated method, roll coater method, etc. Representative examples of substrates include a silicon wafer, gallium, arsenic wafer, glass, ceramic, copper sheet, and substrates obtained by forming elements on said substrates.

The coating film consisting of the optically-cross-linkable polymer composition which has been applied to the substrate subsequently undergoes a drying process. In the present drying process, a circular oven, hot plate, infrared heater, etc. are usually used for baking purposes, although they do not constitute an exhaustive list. It is desirable that the baking temperature be 50-120°C. The optimal drying time depends on the film thickness, but it ranges from 3 min. to 15 hours. It is desirable that the dry coating film thickness be 0.1-200 µm, although it may also deviate from this range.

The coating film of the optically-cross-linkable polymer composition which has been thus applied to and dried on the substrate subsequently undergoes an imagewise exposure process. An example of exposure methods is a method wherein ultraviolet rays are irradiated via a photomask by using an ultraviolet exposure machine which is commonly used in photoresist processes.

The optimal exposure time depends on the types and quantities of optically-cross-linkable polymers and additives as well as the light intensity of the exposure machine. Generally speaking, however, the optimal duration ranges from 1 sec. to 1 hour.

A thermal treatment may also be performed after the exposure. In such a case, it is desirable that the thermal treatment temperature be 40-150°C and that its duration be 1 sec. to 1 hour. As in the case of the baking method, a circular oven, hot plate, infrared heater, etc. can be employed.

Subsequently, the coating film which has been exposed imagewise undergoes a development process. The segments which have been cured and solvent-insolubilized as a result of imagewise exposure remain on the substrate, whereas non-exposed and solvent-soluble segments are dissolved and removed by using a solvent in the development process. As far as the present invention is concerned, a solution obtained by adding dimethyl sulfoxide to a solvent which exhibits a high solubility vis-a-vis said polymer or a mixed solvent consisting of said high-solubility solvent and a low-solubility solvent is employed as a solvent to be used for said development (i.e., development solution). The rate at which the polyimide precursor is developed increases as a result of the addition of dimethyl sulfoxide, and a stable patterning process which is virtually unaccompanied by residual non-exposed segments can be implemented.

Concrete examples of high-solubility solvents include N,N'-dimethylformamide, N,N'-dimethylacetamide, cyclopentanone, cyclohexanone, N-methylpyrrolidone, τ-butyrolactone, hexamethylphosphoric triamide, acetonitrile, tetrahydrofuran, etc. Other solvents which are capable of solubilizing said polymer can be used. These solvents may be used alone or as mixtures consisting of two or more types.

Concrete examples of low-solubility solvents include methanol, ethanol, isopropyl alcohol, water, toluene, chloroform, ethylbenzene, isopropylbenzene, acetone, methyl ethyl ketone, methyl Cellosolve, ethyl Cellosolve, isopropyl Cellosolve, n-propyl alcohol, isobutyl alcohol, etc. These examples, however, do not constitute an exhaustive list. These solvents may be used alone or as mixtures consisting of two or more types.

The development rate is accelerated in the present invention by using the aforementioned development solution. As a result, a patterned polyimide resin coating film with a high resolution can be consistently formed.

The quantity of used dimethyl sulfoxide is selected within a range of 1-30 wt%. The optimal quantity is selected in consideration of the types of polymers, types of additives, and the high-solubility solvent/low-solubility solvent mixing ratio. If the quantity of dimethyl sulfoxide exceeds the aforementioned range, the development rate can be accelerated, but the polyimide precursor in the exposed segment is also solubilized. As a result, the residual film ratio decreases, and the pattern formation may become impossible, or process-related problems (e.g., cracking of the exposed segment, etc.) may be observed.

Concrete examples of development methods include the spray development method, dip development method, ultrasonic development method, paddle development method, etc.

The developed and patterned polyimide precursor coating film is washed with a rinsing solution immediately thereafter for the purpose of removing the development solution and solubilized polyimide precursor.

Concrete examples of rinsing solutions include acetone, methyl ethyl ketone, methyl Cellosolve, ethyl Cellosolve, methanol, ethanol, n-propyl alcohol, i-sopropyl alcohol, toluene, xylene, ethylbenzene, water, 1-methoxy-2-propanol, etc. These examples, however, do not constitute an exhaustive list. They may be used alone or as mixtures of two or more types.

The resulting patterned polyimide precursor coating film is thermally cured at a final temperature of 200-550°C for 5 min. to 5 hours, and as a result, it is converted into a polyimide resin film. It is desirable that thermal curing methods include methods which utilize a circular oven, hot plate, infrared heater, etc. Other mechanisms can also be employed so long as the objective thermal curing effects can be achieved.

If an optically-cross-linkable polymer composition is patterned by the method of the present invention, shortcomings of conventional methods (e.g., low resolution, residual non-exposed segment, long development time, etc.) can be significantly alleviated, and a high-resolution patterned polyimide coating film can be consistently obtained.

In the paragraphs to follow, the effects of the present invention will be explained in further detail with reference to application examples. It should be noted, however, that the scope of the present invention is in no way restricted to these application examples.

### EXAMPLES

### Polyimide Precursor Production Example

After 3,3',4,4'-biphenyltetracarboxylic acid anhydride and p-phenylenediamine had been mixed with N-methyl-2-pyrrolidone at a weight ratio of 13.9%, the contents were agitated, and as a result, 36.00 g of polyamic acid was obtained.

After 0.008 g of 1,4,4-trimethyl-2,3-diazabicyclo(3,2,2)non-2-ene-2,3-dioxide, 0.1 g of 2-mercaptobenzoxazole, 0.3 g of bis(2-o-chlorophenyl-4,5-diphenyl)imidazole, and 0.151 g of 4,4'-(diethylamino)benzophenone had been mixed with the resulting substance, the contents were agitated over a 8-hour period. After 3.926 g of N,N-dimethylaminoethyl methacrylate had subsequently been mixed with the resulting mixture, the contents were agitated over a 8-hour period. After the resulting product had been filtered, resin varnish 1 was obtained as a homogeneous solution.

### APPLICATION EXAMPLE 1

After resin varnish 1 had been coated on a silicon wafer by using a spin coater, it was baked on a hot plate at 90°C and 110°C for 3 min. each, and as a result, a film with a thickness of 20 µm was obtained. After a photomask on which a 3-20 µm line and space pattern had been printed had been contiguously attached to said film, exposure was carried out over a 40-sec. period (cumulative time) by using exposure machine PLA-501F (manufactured by Canon, Inc.). A non-exposed wafer was also prepared and used for calculating the development time. In other words, the development time elapsed before the polyimide precursor coated on said wafter had been completely removed was recorded, and the development was carried out over a period corresponding to 1.5 equivalents of said time.

Subsequently, paddle development was preformed by using an N-methylpyrrolidone/methanol/water/dimethyl sulfoxide = 43.4/23.1/3.5/30 (weight ratio) development solution, and subsequently, a spray rinse was carried out over a 16-sec period by using isopropyl alcohol as a rinsing solution. The development time was 548 sec. The development speed was significantly improved as compared with Application Example 4 (see below). The resolution (i.e., narrowest line width) of the resulting pattern was 10 µm. The resulting pattern was sharp, and no undercut, swelling, etc. were observed whatsoever.

### COMPARATIVE EXAMPLE 1

After a coating film had been formed according to procedures identical to those in Application Example 1, it was exposed over a 40-sec. period, and subsequently, paddle development was carried out by using an N-methylpyrrolidone/methanol/water/dimethyl sulfoxide = 24.8/13.2/2/60 (weight ratio) development solution. The development time was as short as 180 sec., but the developed pattern was cracked, and the residual film ratio was 30%, which is problematic in consideration of the process management.

### APPLICATION EXAMPLES 2 THROUGH 5

Experiments were carried out under different conditions (e.g., development solution composition, etc.). The instruments used were identical to those in Application Example 1.

The conditions and results of the foregoing application examples and comparative examples are summarized in Table I.

**Table I**

| | Film Thickness (µm) | Exposure Time (sec.) | Development Method | N-methylpyrrolidone/methanol/water/dimethyl sulfoxide (weight ratio) |
|---|---|---|---|---|
| App. Ex. 1 | 20 | 40 | Paddle | 43.4/23.1/3.5/30 |
| 2 | 20 | 40 | Paddle | 49.6/26.4/4/20 |
| 3 | 20 | 40 | Paddle | 55.8/29.7/4.5/10 |
| 4 | 10 | 40 | Paddle | 43.4/23.1/3.5/30 |
| 5 | 10 | 40 | Paddle | 55.8/29.7/4.5/10 |
| Comp. Ex. 1 | 20 | 40 | Paddle | 24.8/13.2/2/60 |
| 2 | 20 | 40 | Paddle | 62/33/5/0 |
| 3 | 10 | 40 | Paddle | 62/33/5/0 |

| | Development Time | Resolution (µm) | Presence or absence of cracks | Baking conditions |
|---|---|---|---|---|
| App. Ex.1 | 548 | 10 | Absent | 90°C 3 min./110°C 3 min. |
| 2 | 672 | 10 | Absent | 90°C 3 min./110°C 3 min. |
| 3 | 795 | 10 | Absent | 90°C 3 min./110°C 3 min. |
| 4 | 96 | 7 | Absent | 60°C 3 min./90°C 3 min. |
| 5 | 216 | 7 | Absent | 60°C 3min./90°C 3 min. |
| Comp. Ex. 1 | 180 | - | Present | 90°C 3 min./110°C 3 min. |
| 2 | 994 | 15 | Absent | 90°C 3 min./110°C 3 min. |
| 3 | 270 | 10 | Absent | 60°C 3 min./90°C 3 min. |

## Claims

1. A method for forming a patterned polyimide coating film on a substrate comprising the following steps:
(1) applying an optically-cross-linkable polymer composition obtained by modifying a polyimide precursor derived from an aromatic tetracarboxylic acid or a corresponding mono- or diacid anhydride and an aromatic diamine by using a photosensitive group-containing compound to the surface of a substrate in such a way that a coating film will be formed,
(2) exposing the coating film imagewise,
(3) removing non-exposed segments by using a development solution, and
(4) heating the remaining coating film in the exposed segment.

2. The development solution of Claim 1 in which the solution contains at least 1 wt% and no more than 30 wt% of dimethyl sulfoxide.
